# EUROPEAN PATENT SPECIFICATION

(11) **EP 4 128 362 B1**
(45) Date of publication and mention of the grant of the patent: **22.11.2023**
(21) Application number: 22717131.1
(22) Date of filing: 22.03.2022
(51) Int. Cl.: H01L 29/78, H01L 29/739, H01L 29/04, H01L 29/06, H01L 29/16, H01L 29/423

(54) **POWER SEMICONDUCTOR DEVICE**
LEISTUNGSHALBLEITERBAUELEMENT
DISPOSITIF SEMI-CONDUCTEUR D'ALIMENTATION

(30) Priority: 22.03.2021 EP 21163959
(43) Date of publication of application: 08.02.2023
(73) Proprietor: Hitachi Energy Switzerland AG, 5400 Baden (CH)
(72) Inventor: ARANGO, Yulieth, 8045 Zurich (CH); ROMANO, Gianpaolo, 5400 Baden (CH); MIHAILA, Andrei, 5415 Rieden (CH); BELLINI, Marco, 8005 Zürich (CH); KNOLL, Lars, Hägglingen 5607 (CH)
(74) Representative: Epping - Hermann - Fischer
(86) International application number: PCT/EP2022/057471
(87) International publication number: WO 2022/200338

(56) References cited:
- EP-A1- 2 750 198
- WO-A1-2005/048352
- WO-A1-2018/163286
- WO-A1-2020/135378
- JP-A- H09 260 650
- US-A- 6 060 747
- US-A1- 2013 313 635
- US-A1- 2016 260 798
- US-A1- 2016 359 026
- US-A1- 2018 240 906

## Description

A power semiconductor device is provided.

Documents US 10,014,376 B2, US 2013/0062629 A1 and US 2013/0065384 A1 refer to the manufacture of SiC power devices.

Documents US 2016/0260798 A1, US 6 060 747 A, WO 2005/048352 A1, JP H09-260 650 A, EP 2 750 198 A1 and WO 2020/135378 A1 refer to semiconductor devices having a trench structure.

Document US 2018/0240906 A1 refers to a switching element that includes a semiconductor substrate, first and second trenches, a gate insulating layer, an interlayer insulating layer covering the semiconductor substrate, and an electrode on the interlayer insulating layer. A wide portion and a narrow portion may be arranged alternately between the first and second trenches. The interlayer insulating layer may include a contact hole in the wide portion. The electrode may be in contact with the semiconductor substrate within the contact hole. The semiconductor substrate may include an upper n-type region in contact with the gate insulating layer in the narrow portion and in contact with the electrode, a p-type body contact region in contact with the electrode, a p-type body region in contact with the gate insulating layer in the narrow portion, and a lower n-type region in contact with the gate insulating layer in the narrow portion.

Documents WO 2018/163286 A1 and US 2013/0313635 A1 refer to semiconductor devices. Specifically, document US 2013/313635 A1 discloses a vertical power device provided with a trench gate arranged in a rectangular grid-like pattern. A breakdown voltage-maintaining region is provided selectively on a side surface or a bottom surface of the trench. In particular, in locations where different sections of the gate trench intersect with each other, the gate trench is surrounded by the breakdown voltage-maintaining region on the side surface and at the bottom surface. Conversely, in locations where there are provided straight sections of the gate trench, the breakdown voltage-maintaining region is provided selectively only at the bottom surface of the gate trench.

A problem to be solved is to provide a power semiconductor device having an improved current density in an on-state.

This object is achieved by a power semiconductor device as defined in the independent patent claim. Exemplary further developments constitute the subject-matter of the dependent patent claims.

The power semiconductor device, which is, for example, based on a wide bandgap material, exemplarily silicon carbide, SiC for short, comprises a trench which has side walls with an extended length compared with just straight running trenches. Hence, an effective contact area between the trench and a channel region can be increased, resulting in a larger effective channel width, and a lower resistance of the power semiconductor device in an on-state can be achieved.

Thus, the power semiconductor device , as defined in the independent claim, comprises a semiconductor body, at least one source region of a first conductivity type in the semiconductor body at a top side thereof, at least one channel region of a second conductivity type in the semiconductor body below the at least one source region, a drift region of the first conductivity type in the semiconductor body below the at least one channel region, and at least one trench running from the top side through the at least one source region and through the at least one channel region and ending in the drift region. The at least one trench accommodates a gate electrode. Seen in top view of the top side, the at least one trench comprises non-linearly running side walls. There is a shield region which is of the second conductivity type and which is located below at least a part of the bottom side of the at least one trench, and seen in top view of the top side, the at least one trench comprises a plurality of branch-offs, the shield region extends completely or partially below one, some or all of the branch-offs.

For example, the semiconductor body is of SiC. However, the semiconductor body can alternatively be of Si or of another high-bandgap semiconductor material like Ga₂O₃ or GaN.

For example, the first conductivity type is n-type and the second conductivity type is p-type. Although in the following the description of the embodiments focusses on the afore-mentioned conductivity types, it is also possible that the first conductivity type is p-type and the second conductivity type is n-type.

The top side of the semiconductor body may be of planar fashion, despite in the area of the at least one trench.

Here and in the following, the term 'source region' may refer both to a source in a field-effect transistor as well as to a emitter in a bipolar transistor.

It is possible that there is only one drift region completely extending across the semiconductor body in a direction perpendicular to a growth direction of the semiconductor body. However, in principle there can be a plurality of drift regions. For simplification, in the following examples only one drift region is explicitly mentioned.

A maximum doping concentration in the at least one channel region and in the at least one drift region may be lower than in the at least one source region.

Along the growth direction and/or along a direction perpendicular to the top side, the at least one source region, the at least one channel region and the drift region may directly follow on one another in the stated order. However, as an option, there may be at least one buffer layer and/or transition layer in-between the at least one source region, the at least one channel region and/or the drift region.

The at least one trench ends within the drift region so that the at least one trench does not completely run through the drift region. However, the trench completely traverses the at least one source region and the at least one channel region in a direction perpendicular to the top side.

At a bottom side of the trench, there is a shield region which is of the second conductivity type. The shield region is completely embedded between the at least one trench and the drift region.

The shield region is limited to the at least one branch-off. That is, the central pipe is provided with the shield region for at most 10% of an area of the central pipe, and the at least one branch-off is provided with the shield region for at least 80% or for at least 90% of an area of the at least one branch-off, seen in top view of the top side.

The gate electrode is completely accommodated in the at least one trench. Otherwise, the gate electrode may protrude from the at least one trench, for example, to enable external electrical contacting the gate electrode. Per trench, there is exactly one gate electrode. If there is a plurality of the trenches, there may be one separate gate electrode per trench, or there is a common gate electrode for all the trenches, or there are groups of trenches sharing one gate electrode.

The gate electrode is separated from the semiconductor body by means of a gate insulator. For example, the gate insulator is of at least one of the following materials: SiO₂, Si₃N₄, Al₂O₃, Y₂O₃, ZrO₂, HfO₂, La₂O₃, Ta₂O₅, TiO₂.

In the power semiconductor device described herein, an enhancement of the effective channel region size, for example, in silicon carbide, SiC, trench MOSFET devices is proposed. The design introduces alternating, for example, rectangular or zigzag type, step features changing around in-plane perpendicular to the [0001]-direction, which may be a direction referring to a trench depth, so that the side walls are formed not only along the [1100]-direction, but also along the [1120]-direction, wherein the semiconductor body may be of 4H-SiC. The aforementioned designs are not claimed but they are useful for understanding the invention. Compared to an only stripe-like trench, this design allows to maximize the total width of the channel region in the device for a given pitch size. The additional parallel conduction of the extra side wall portions in the trench enables high current capability, and therefore lower on-state resistance, also referred to as R_{ON}.

Trench gate power MOSFET devices represent one of the most promising technologies to meet the energy efficiency demand and performance requirements in power electronics. One approach in developing a trench MOSFET device is the so-called V-grooved MOSFET, VMOSFET for short. The generation of high electric fields at the tip of fully etched sharp V-structures can be partially reduced by the premature termination of the etching step as to produce a flat bottom groove, at expenses of reducing high scale integration capability. This design can further be improved by opening rectangular grooves where the trench side walls, typically etched along non-polar crystal faces, define the MOS inversion channel. This UMOSFET-type called structure offers a significant reduction in on-state resistance per unit area due to the absence of the junction field-effect transistor, JFET, region, which leads to smaller cell-pitches, and also because of the higher mobility of charge carriers on the non-polar faces in SiC devices. The aforementioned designs are not claimed but they are useful for understanding the invention.

Some other promising designs include so-called pn super junctions, SJ for short, which have been intended to improve the trade-off between specific on-state resistance and breakdown voltage. This may be achieved by forming a parallel array of p-doped and n-doped thin layers interposed in the drift region. Reduction of on-state resistance and high breakdown voltage can be achieved by means of proper control of the maximum doping concentrations and the thicknesses of these layers. The aforementioned designs are not claimed but they are useful for understanding the invention.

Vertical trench gate MOSFET devices based on SJ structures are much more challenging to fabricate compared to planar devices but have shown a reduction of about 30% or even more in R_{ON} with respect to the conventional trench gate structures. SJ trench designs are promising but involve a higher level of complexity during device processing.

The lateral scaling, or pitch reduction, has been one of the most adopted approaches for lowering R_{ON}, probably due to a more straightforward process implementation, but it is strongly limited by integration constraints and it increases a gate charge. However, vertical trench MOSFETs offer much more flexibility, and the combination of larger effective channel area and higher mobility along the non-planar trench side walls enables lower on-state resistance in comparison to the conventional planar MOSFET.

In the semiconductor device described herein, for example, the device comprises a trench etched deep inside the [0001]-direction into the semiconductor body and having short sections of trench sidewalls parallel to the [1100]-direction and the [1120]-direction. Thus, the side wall orientation changes alternatively from one to other direction whereas the main axis of the at least one trench propagates along the [1100]-direction like in the conventional trench MOSFET design. The advantage of the design proposed herein is, for example, that for a given pitch size the resulting channel region width increases compared to the estimated width in a conventional UMOSFET trench.

Thus, in this proposed design, the side wall area of the at least one trench along the [1100]-direction equals the total trench side wall area in the standard stripe-like trench design. Therefore, all those side wall portions etched along the [1120]-direction introduce additional contributions, resulting in, for example, roughly 40% increase of channel area for the same cell pitch. The optimal side wall step length along the [1120]-direction can be chosen according to the trade-off between increasing channel width and preventing too large pitch size.

According to at least one embodiment, the semiconductor body is of SiC and a direction of main extent of the at least one trench runs along a [1100]-direction of the SiC. The direction of main extent may be that region along which the at least one trench has its maximum geometric dimension and/or that is along a longest axis of symmetry of the respective trench.

According to at least one embodiment, at least one or some or each one of the side walls comprises at least one portion next to the at least one source region running transversely to the [**1̅**100]-direction of the SiC. For example, said portion runs perpendicular to the [**1̅**100]-direction, for example, along the [11**2̅**0]-direction. Otherwise, an angle between the [**1̅**100]-direction and said side wall portion is at least 45° or at least 60° or at least 70° and/or at most 85° or at most 75°. It is possible that different transversely running side wall portions have different angles towards the [**1̅**100]-direction.

According to at least one embodiment, seen in top view of the top side, an overall length of at least one, of some or of each one of the side walls exceeds a length of the at least one trench by at least a factor of 1.2 or by at least a factor of 1.3 or by at least a factor of 1.4. The length of the at least one trench may refer to an extent of the respective trench along the direction of main extent. The length of the at least one trench may also be called effective extension or effective length. Exemplarily, the non-linearly running side walls, for example, the increase of overall length of the side walls compared to the effective length of the gate, is present over the whole depth direction of the trench. Thus, by means of the non-linearity of the side walls, seen in top view of the top side, the length of the side walls and, hence, the channel region are can significantly be increased.

According to at least one embodiment, with a tolerance of at most 15° or of at most 5°, the side walls are oriented perpendicular to the top side. Optionally, a trench bottom runs in parallel with the top side, for example, with a tolerance of at most 15° or of at most 5°, too. The bottom side may connect the two side walls of the respective trench. Thus, the respective trench may be U-shaped or U-shaped when seen in cross-section through the top side and perpendicular to the direction of main extent. Of course, the features in this paragraph may be combined, for example, with some or all of the features in the previous paragraph.

According to at least one embodiment, seen in top view of the top side, the at least one trench comprises a central pipe running straightly along the direction of main extent. For example, the central pipe is of constant, non-varying width, seen in top view of the top side. Further, the central pipe may be of constant thickness, in the direction away from the top side. That is, the central pipe may be formed as a linear bar.

The at least one trench comprises a plurality of branch-offs branching from the central pipe. The branch-offs are regarded as lateral extensions of the central pipe. The branch-offs may be arranged at the central pipe in a regular and/or equidistant manner.

If a trench comprises a plurality of branch-offs on opposite side walls, the branch-offs may be arranged symmetrically on both side walls, that is, facing each other, or the branch-offs may be arranged in an offset or displaced manner.

According to at least one embodiment, one or some or all of the branch-offs are of square or rectangular shape, seen in top view of the top side. That is, the respective neighboring portions of the at least one respective side wall are arranged perpendicular to one another.

According to at least one embodiment, one or some or all of the branch-offs are of trapezoidal shape, seen in top view of the top side. The respective trapezoid is, for example, a symmetric trapezoid with an axis of symmetry perpendicular to the direction of main extent of the respective trench. Alternatively or additionally, one or some or all of the branch-offs may be of polygonal shape when seen in top view of the top side.

According to at least one embodiment, one or some or all of the branch-offs which are of trapezoidal shape widen in a direction away from the central pipe, seen in top view of the top side. Hence, a broadest part of the respective branch-off is remote from the central pipe.

According to at least one embodiment, one or some or all of the branch-offs which are of trapezoidal shape narrow in a direction away from the central pipe, seen in top view of the top side. Hence, a broadest part of the respective branch-off is next to the central pipe.

According to at least one embodiment, one or some or all of the branch-offs are of trigonal shape, seen in top view of the top side. That is, the respective trench may appear as a single-sided or double-side saw, seen in top view. At least one or some or all of the trigonal branch-offs may be shaped symmetrically, with an axis of symmetry perpendicular to the direction of main extent of the respective trench. An opening angle of the triangle forming the respective branch-off, at a tip facing away from the central pipe, is, for example, at least 45° or at least 90° or at least 120°. Alternatively or additionally, said opening angle is at most 150° or at most 125° or at most 100°. For example, the opening angle is between 90° and 150° inclusive or between 45° and 125° inclusive.

According to at least one embodiment, each one of the side walls comprises a plurality of the branch-offs. All the branch-offs of the respective side wall, or all the branch-offs of the respective channel, may be of the same shape. Otherwise differently shaped branch-offs may be combined in the respective trench.

The power semiconductor device further comprises a plurality of plugs of the second conductivity type in the semiconductor body at the top side. The plugs are configured to provide electric contact paths from the top side to the at least one channel region. Hence, the plugs traverse the at least one source region and are in direct contact with the at least one channel region as well as with the top side. It is possible that the plugs and the at least one source region, and consequently the at least one channel region, are on the same electric potential.

According to at least one embodiment, the plugs are arranged distant from the at least one trench, seen in top view of the top side. In this case, the plugs may not touch the at least one trench. The at least one source region may be arranged between the plugs and the at least one trench. Otherwise, the plugs could touch the at least one trench, for example, in a point-like manner, that is, there may be no contact surfaces but only contact lines between the at least one trench and the respective plug.

Seen in top view of the top side, there are straight strips next to the at least one trench, the at least one trench is located between two adjacent straight strips. The straight strips may touch the at least one assigned trench, for example, in a point-like manner, or the straight strips are distant from the at least one assigned trench. In the straight strips, portions of the at least one source region and the plugs are arranged in an alternating manner.

According to at least one embodiment, the power semiconductor device comprises a plurality of the trenches and a plurality of the source regions. Seen in top view of the top side, the trenches and the at least one associated source region could be arranged in an alternating manner in a direction transverse to the trenches. The trenches may be arranged in parallel with each other, that is, with parallel directions of main extent or with parallel axes of symmetry.

According to at least one embodiment, the power semiconductor device is a field-effect transistor or an insulated gate bipolar transistor. For example, the power semiconductor device described herein is or is comprised in, for example, a MOS-based SiC trench device such as MOSFETs and IGBTs. Hence, the power semiconductor device is or can be present in, for example, a device selected from the group comprising or consisting of a metal-oxide-semiconductor field-effect transistor (MOSFET), a metal-insulator-semiconductor field-effect transistor (MISFET), an insulated-gate bipolar transistor (IGBT), a bipolar junction transistor (BJT), and a junction gate field-effect transistor (JFET). The power semiconductor device described herein may also be part of a thyristor like a gate turn-off thyristor (GTO) or a gate commutated thyristor (GCT).

According to at least one embodiment, the semiconductor body further comprises a collector region. The collector region is of the same conductivity type as the channel region. The collector region may be located at a bottom side of the semiconductor body opposite the top side. There can be one collector region for all the source regions, if there is a plurality of source region. A collector electrode can be directly applied to the collector region. If there is a collector region, the power semiconductor device can be an IGBT.

According to at least one embodiment, the semiconductor further comprises at least one drain region. The drain region is of the same conductivity type as the at least one source region. For example, the drain region is a layer at the bottom side. For example, the drift region is located between the at least one source region and the drain region. There can be one common drain region for all the source regions, if there is a plurality of source region. A drain electrode may be in direct contact with the at least one drain region. If there is a drain region, the power semiconductor device can be a MOSFET or a MISFET.

According to at least one embodiment, the power semiconductor device comprises at least two of the source regions and a source electrode. The source electrode is in electric contact, for example, in direct contact, with at least two of the source regions or with all source regions. Hence, said at least two source regions can be on the same electric potential. As an option, the source electrode may also be in direct contact with the at least one plug.

According to at least one embodiment, seen in cross-section perpendicular to the top side, the gate electrode is located between the at least two source regions. Hence, two source regions can be assigned to one gate electrode. The source regions may be arranged in a symmetric manner next to the respective gate electrode.

According to at least one embodiment, the power semiconductor device is a power device. For example, the power semiconductor device is configured for a maximum current through the at least one channel region of at least 1 A or of at least 20 A. Alternatively or additionally, the power semiconductor device is configured for a maximum voltage of at least 0.2 kV or of at least 0.6 kV or of at least 1.2 kV.

The power semiconductor device is, for example, for a power module in a vehicle to convert direct current from a battery to alternating current for an electric motor, for example, in hybrid vehicles or plug-in electric vehicles. Moreover, the power semiconductor device can be a fuse, for example, in a vehicle like a car.

A power semiconductor device is explained in greater detail below by way of embodiments with reference to the drawings; although these embodiments are not covered by the claims, they are useful for understanding the present invention as specified in the claims. Elements which are the same in the individual figures are indicated with the same reference numerals. The relationships between the elements are not shown to scale, however, but rather individual elements may be shown exaggeratedly large to assist in understanding.

In the figures:
- Figure 1: is a schematic perspective view of an embodiment of a power semiconductor device described herein,
- Figure 2: is a schematic top view of the power semiconductor device of Figure 1,
- Figures 3 and 4: are schematic sectional views of the power semiconductor device of Figure 1,
- Figure 5: is a schematic representation of crystallographic orientations in SiC,
- Figures 6 to 10 and 12: are schematic top views of embodiments of power semiconductor devices according to the present invention described herein,
- Figures 11, 13 and 14: are schematic perspective views of examples of power semiconductor devices according to examples which are not claimed but which are useful for understanding the present invention,
- Figure 15: is a schematic representation of simulated current density data for power semiconductor device described herein,
- Figure 16: is a schematic representation of simulated I-V curves for power semiconductor device described herein, and
- Figures 17 to 18: are schematic top views of power semiconductor devices according to examples which are not claimed but which are useful for understanding the present invention, and
- Figure 19: is a schematic top view of a power semiconductor device according to an embodiment of the invention described herein.

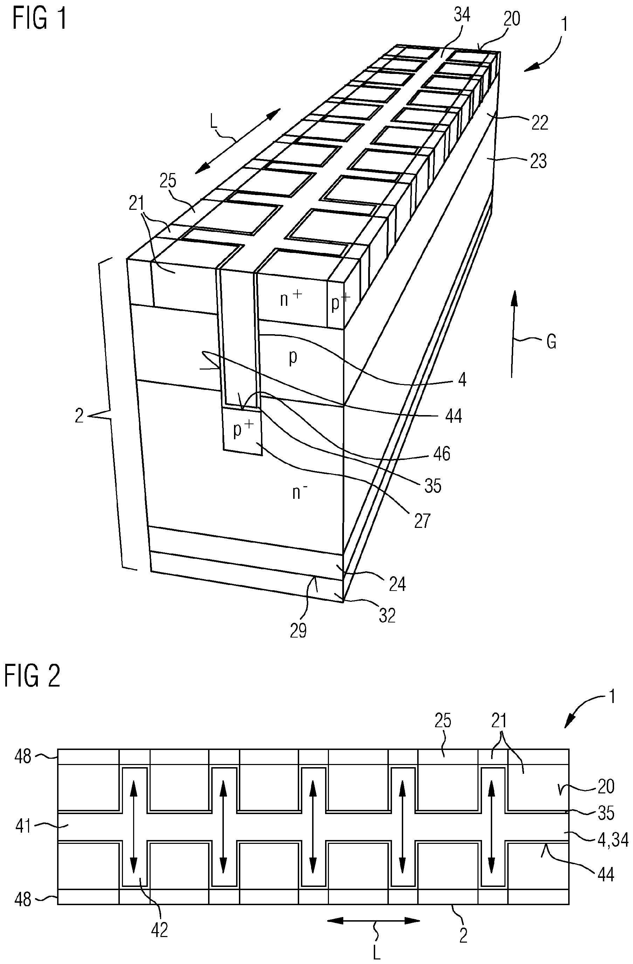

In Figures 1 to 4, an embodiment of a power semiconductor device 1 is illustrated. The power semiconductor device 1 comprises a semiconductor body 2. At a top side 20, the semiconductor body 2 comprises a plurality of source regions 21. Additionally, there is a plurality of plugs 25 on the top side 20, too. The plugs 25 are configured to electrically contact the channel regions 22 which are located below the source regions 21 and the plugs 25. The plugs 25 and the source regions 21 may have the same or different thicknesses along a growth direction G of the semiconductor body 2.

Further, in the semiconductor body 2 there is a drift region 23 below the channel regions 22. The channel region 22 separates the source region 21 from the drift region 23.

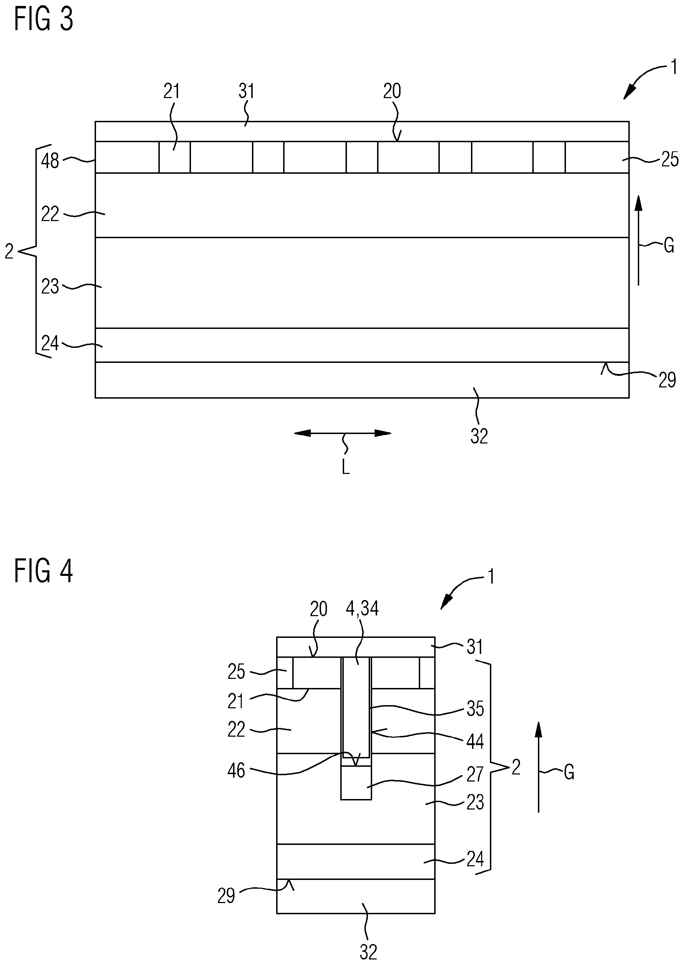

If the power semiconductor device 1 is a MISFET or a MOSFET, then there can be an optional drain region 24 below the drift region 23 at a bottom side 29 of the semiconductor body 2 opposite the top side 20. The drain region 24 is electrically contacted by means of a drain electrode 32. As can be seen, for example, from Figures 3 and 4, at the top side there is a source electrode 31 that electrically contacts all the source regions 21 as well as the plugs 25.

The afore-mentioned regions 21, 22, 23, 24 may directly follow one on top of the other along the growth direction G of the semiconductor body 2. Thus, the semiconductor body 2 may be epitaxially grown at least in part. Further, the semiconductor body 2 may comprise a substrate, now shown, on which the other regions, for example, regions 22, 21, 25, are grown on.

Moreover, there is a trench 4 in the semiconductor body 2 which runs from the top side 20 through the source regions 21 and the channel regions 22 and terminates in the drift region 23. The trench 4 has a direction L of main extent along which the trench 4 comprises a straightly running central pipe 41. To increase an effective channel width, the trench 4 comprises a plurality of branch-offs 42 that run away from the central pipe 41. Hence, due to the branch-offs 42, a length of side walls 44 of the trench 4 is increased. Seen in cross-section, the trench 4 is roughly of U-shape, so that a trench bottom 46 runs in parallel or approximately in parallel with the top side 20, The side walls 44 consequently run perpendicular or approximately perpendicular to the top side 20.

In the trench 4, there is a gate electrode 34. The gate electrode 34 is electrically separated from the semiconductor body 2 by means of a gate insulator 35. A further insulator which electrically separates the source electrode 31 from the gate electrode 34 is not explicitly shown in the figures. For simplicity, the gate insulator 35 is not illustrated in the following figures.

Below the trench 4, at the trench bottom 46 and embedded in the drift region 23, there is a shield region 27.

According to examples not forming part of the present invention but useful for its understanding, the shield region 27 may be below the central pipe 41 and below the branch-offs 42, or only below the central pipe 41.

The shield region 27 below the trench bottom 46 which may be produced by implanting ions can be used in order to shield the gate insulator 35 from high electric fields in the blocking condition. The shield region 27 can either be left floating, or can be contacted to the same source region potential. Seen in cross-section, the shield region 27 may be of square or rectangular shape.

Seen in top view, the branch-offs 42 are of rectangular shape and are arranged in a regular manner The branch-offs 42 at the two side walls 44 lie opposite to one another so that a long axis of symmetry of the trench 4 runs along the direction L of main extent. It is possible that an extent of the branch-offs 42 in the direction away from the central pipe 41 is larger than a width of the central pipe 41 without the branch-offs 42. Moreover, a distance between adjacent branch-offs 42 may be larger than a length of the branch-offs 42, in the direction perpendicular to the central pipe 41, and may also be larger than the width of the central pipe 41.

There are strips 48 running in parallel with the direction L of main extent. The strips 48 are of straight fashion. In the strips 48, the source regions 21 and the plugs 25 are arranged in an alternating manner. In this respect, according to a first alternative of the invention, the source regions 21 are only at front ends of the branch-offs 42 so that at corners of the branch-offs 42 close to the strips 48, the plugs 25 touch the trench 4, for example, in a point-like fashion, seen in top view, compare Figure 2. Hence, the strips 48 are in contact with the trench 4 only at the front ends of the branch-offs 42. Areas between adjacent branch-offs 42 are completely composed of the source regions 21.

In Figures 1 and 2, the semiconductor body 2 comprises only one trench 4. However, the configuration shown in Figures 1 and 2 can be regarded as a basic unit that may be arranged next to one another various times, for example, in a repetitive manner. Hence, the basic units can be adjacent to one another and, in the direction perpendicular to the direction L of main extent, a couple of said basic units may follow one another. Accordingly, a pitch of the basic units and therefore a pitch of the trenches may correspond to the width of the respective trench 4 at the branch-offs 42, plus once or twice a width of the strips 48.

For example, the source regions 21 and the optional drain region 24 are highly n⁺-doped and the drift region 23 is lower n-doped or n⁻-doped; the channel regions 22 are p-doped and the optional plugs 25 are higher p⁺-doped as well as the optional shield region 27. Otherwise, the doping types could all be inverted.

For example, maximum doping concentrations of the source regions 21, the optional drain region 24 and the plugs 25 are at least 1 × 10¹⁸ cm⁻³ or at least 5 × 10¹⁸ cm⁻³ or at least 1 × 10¹⁹ cm⁻³ and/or at most 5 × 10²⁰ cm⁻³ or at most 2 × 10²⁰ cm⁻³ or at most 1 × 10²⁰ cm⁻³. Further, a maximum doping concentration of the channel regions 22 may be at least 5 × 10¹⁶ cm⁻³ or at least 1 × 10¹⁷ cm⁻³ and/or at most 5 × 10¹⁹ cm⁻³ or at most 5 × 10¹⁸ cm⁻³. Depending on the voltage class of the power semiconductor device 1, a maximum doping concentration of the drift region 23 may be at least 1 × 10¹⁴ cm⁻³ or at least 5 × 10¹⁴ cm⁻³ or at least 1 × 10¹⁵ cm⁻³ and/or at most 1 × 10¹⁷ cm⁻³ or at most 5 × 10¹⁶ cm⁻³ or at most 1 × 10¹⁶ cm⁻³.

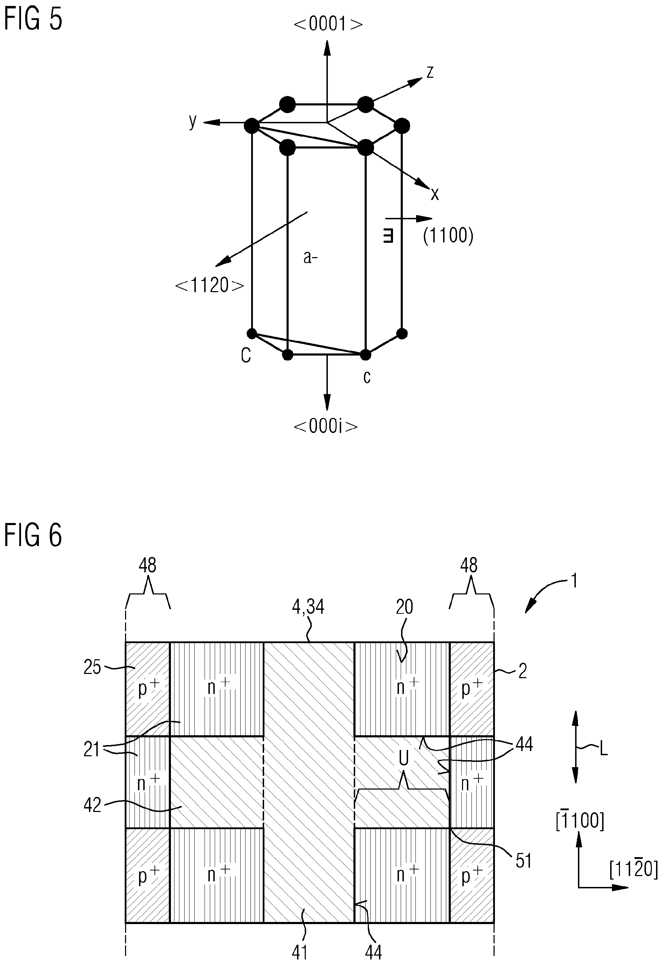

For better understanding, in Figure 5 the basic crystallographic planes of SiC are illustrated because the power semiconductor device 1 described herein may be based on SiC. It is noted that the trenches 4 described herein may run into the semiconductor body along the [0001]-direction and that the direction L of main extent is along the [1100]-direction so that the central pipe 41 is in parallel with the [1100]-direction. Accordingly, the branch-offs 42 shown in Figure1 1 and 2, for example, may extend into the [1120]-direction. Hence, all the side walls 44 in the embodiment of Figures 1 to 4 may exclusively run along the [1100]-direction and the [1120]-direction.

In Figure 6, another embodiment of the power semiconductor device 1 is illustrated in a top view of the top side 20. Only one primitive cell is illustrated. A plurality of such primitive cells may follow one another along the direction L of main extent so that the basic unit explained above can be composed of more than one such primitive cell, and a plurality of such basic units can be arranged next to one another side by side.

According to Figure 6, an extent of the branch-offs 42 away from the central pipe 41 corresponds to a minimum size U of a structural unit. Thus, U may describe the smallest step size of the channel width. For example, U is at least 0.2 µm or at least 0.5 µm and/or U is at most 5 µm or at most 2 µm. In the strips 48, again the plugs 25 are segmented along the [1100]-direction to prevent increasing pitch size. Seen in top view, in contact points 51 the plugs 25 may touch the trench 4.

Otherwise, the same as to Figures 1 to 5 may also apply for Figure 6.

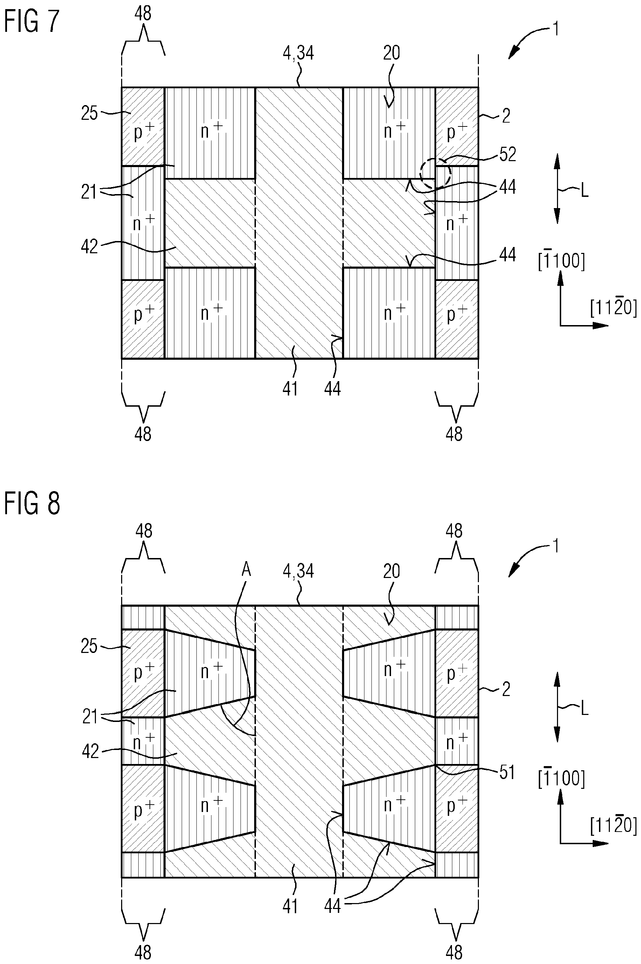

Regarding Figure 7, according to a second alternative of the invention, the source regions 21 in the laterally arranged strip 48 extend along the direction L of main extent towards the plugs 25 so that overlap regions 52 result. This helps to reduce the formation of an extended depletion region around the corner, which would eventually reduce the effective channel width at those points. For example, the overlap regions 52 has an extent along the direction L of at least 0.1 U and/or of at most 0.5 U. For example, a width of the stripe 48 is at least 0.2 U and/or at most 0.8 U.

Accordingly, because of the overlap regions 52 the source regions 21 between adjacent branch-offs 42 merge with the source regions 21 in the strip 48 so that one continuous source region 21 results per side wall 44.

Otherwise, the same as to Figures 1 to 6 may also apply for Figure 7.

According to Figure 8, the branch-offs 42 running away from the central pipe 41 are of trapezoidal shape and narrow in the direction away from the central pipe 41. An axis of symmetry of the branch-offs 42 is oriented perpendicular to the direction L. For example, an angle A between the direction L and the transversely running side wall 44 is at least 45° and/or at most 80°, or is at least 55° and/or at most 70°. Such designs of the branch-offs 42 can be used to optimize the trench performance keeping the same cell pitch.

As in Figure 6, there are contact points 51 at which the plugs 25 as well as the source regions 21 touch the front ends of the branch-offs 42. Again, said front ends of the side walls 44 run in parallel with the direction L.

Thus, the side walls 44 of the at least one trench 4 can be accomplished along different directions apart from [1100] and [1120]. Likewise, the angle A between alternating trench side walls 44 can be chosen to explore benefits from different crystallographic planes perpendicular to top side 20, for example, to improved mobility offered by nonpolar faces of 4H-SiC.

Otherwise, the same as to Figure 6 may also apply for Figure 8.

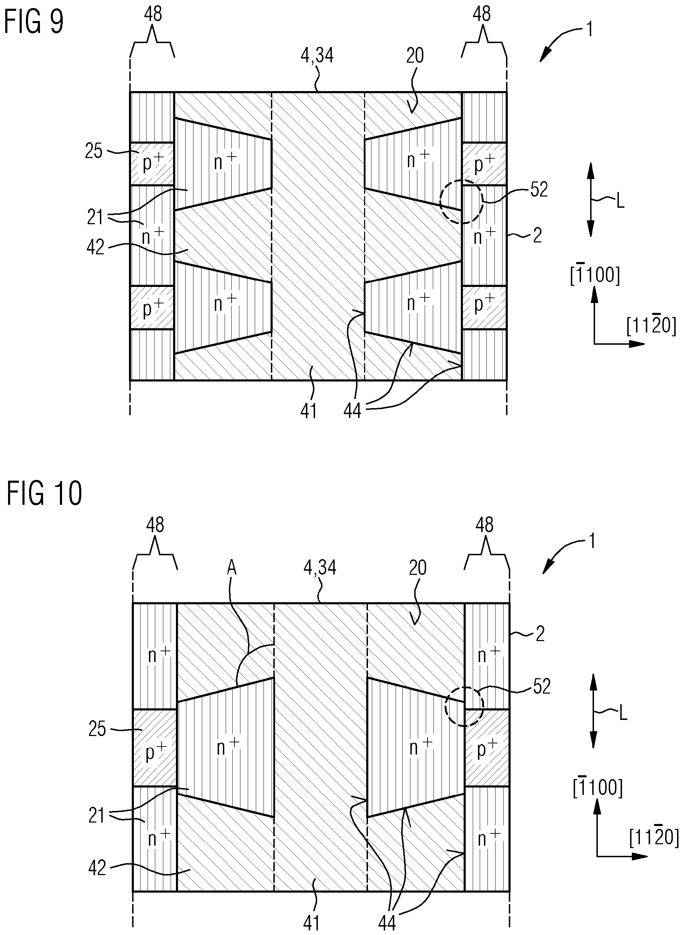

In Figure 9 it is illustrated that there are overlap regions 52 in the strips 48 analogous to Figure 7.

Otherwise, the same as to Figure 8 may also apply for Figure 9.

According to Figure 10, the branch-offs 42 are of trapezoidal shape, too, but widen in the direction away from the central pipe 41. Consequently, the angle A is larger than 90° and is, for example, at least 100° and/or at most 135°, or is at least 110° and/or at most 125°.

The configuration of Figure 10 is illustrated having the contact regions 52, but could of course be realized with contact points 51 instead, compare, for example, Figure 8.

Otherwise, the same as to Figures 1 to 9 may also apply for Figure 10.

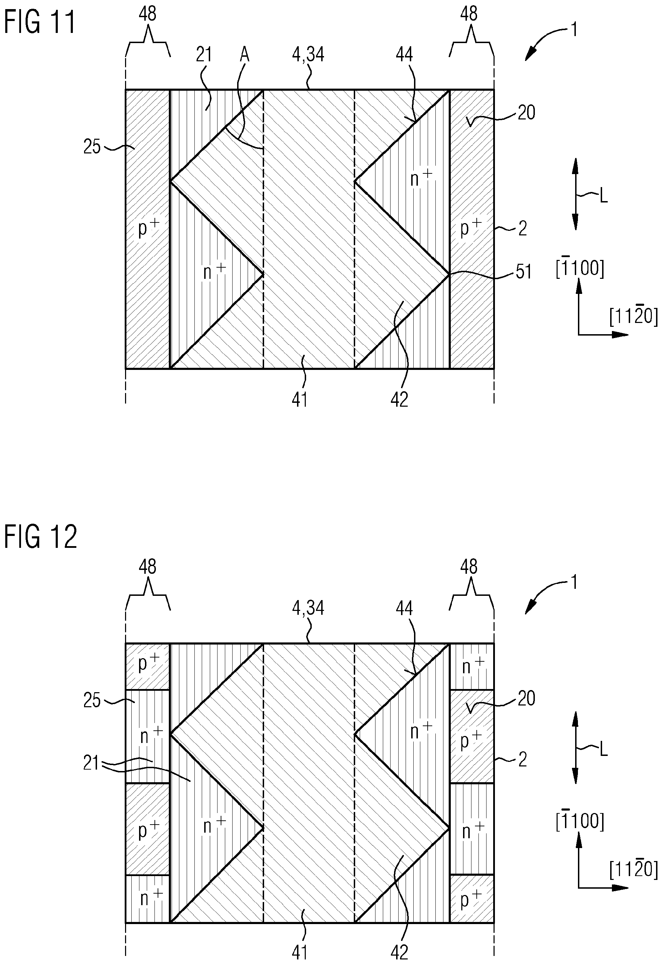

According to an example not forming part of the invention but being useful for its understanding, as shown in Figure 11, the branch-offs 42 are of trigonal shape, seen in top view. Thus, the trench 44 may be free of side walls 44 running along the [1100] and [1120] directions. For example, the angle A is at least 30° and/or at most 80°, or is at least 45° and/or at most 70°.

In Figure 11, there is a continuous strip of the plug 25 along the direction L on each side of the trench 4, seen in top view. Thus, at tips of the branch-offs 42 the plugs 25 may touch the side walls 44. Otherwise, according to the invention, see Figure 12, there are the strips 48 with alternating source regions 21 and plugs 25 so that a continuous, merged source region 21 results on each side of the trench 4, seen in top view.

Otherwise, the same as to Figures 1 to 10 may also apply for Figures 11 and 12.

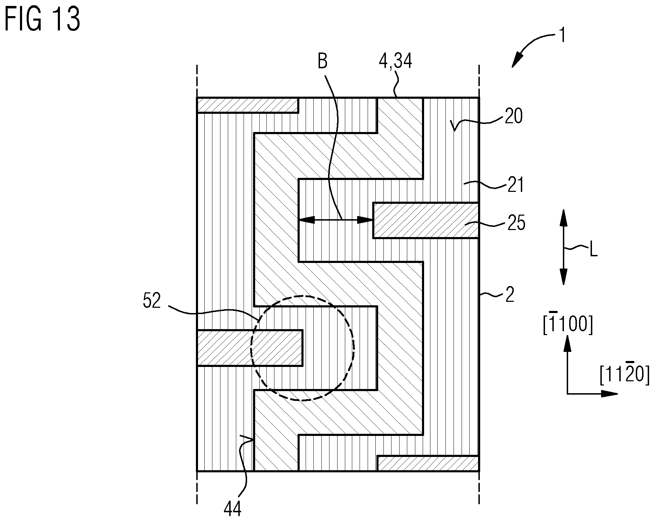

In the embodiments of the invention of Figures 1 to 4, 6 to 10 and 12, as well as in the example of Figure 11 useful for understanding the invention, there is always the continuous, straight central pipe 41 so that ends of the trench 4 can be connected by a straight line which runs only within the trench 4. Contrary to that, according to a further example not forming part of the invention but being useful for its understanding, see Figure 13, the trench 4 is of square signal shape, seen in top view. For example, seen in top view, a width of the trench 4 in areas running in parallel with the direction L is smaller than an inner leg length B of the U's or 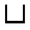 's.

Thus, the sections of the trench 4 are formed of U's or 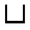 's with alternating orientations, when seen in top view. The optional plugs 25 may range into the U's or 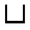 's, or contrary to what is shown in Figure 13, may be distant from inner portions of the U' or 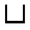 's.

Otherwise, the same as to Figures 1 to 12 may also apply for Figure 13.

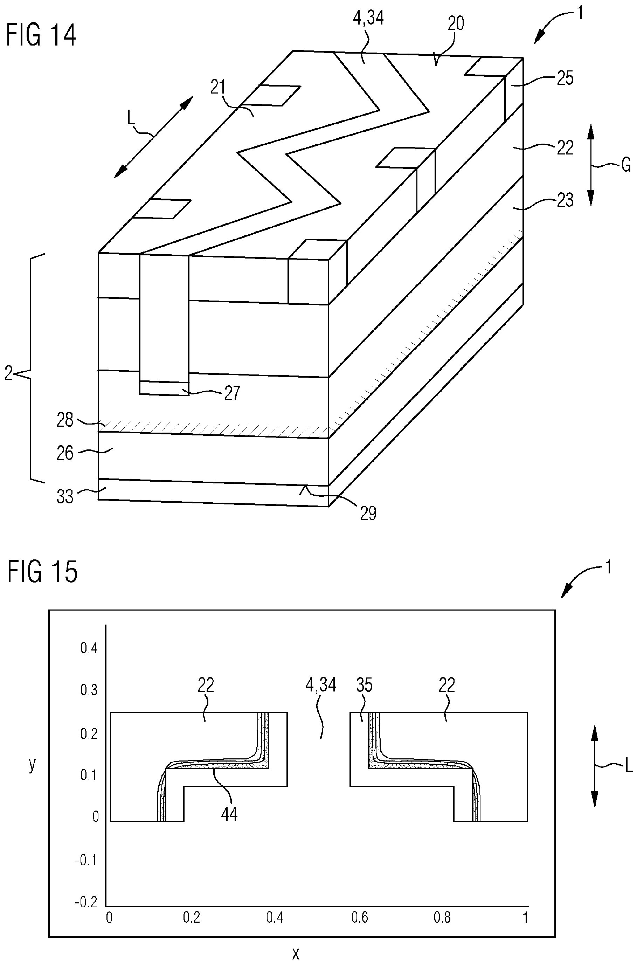

The power semiconductor devices 1 of Figures 1 to 4 and 6 to 13 are configured as trench MISFETs or MOSFETs. Contrary to that, the power semiconductor device 1 of Figure 14 is a IGBT. Otherwise, all the power semiconductor devices 1 of Figures 1 to 4 and 6 to 13 can also be IGBTs, and the power semiconductor device 1 of Figure 14 can be a trench MISFET or MOSFET.

Thus, according to Figure 14, the power semiconductor device 1 comprises a collector region 26 in the semiconductor body 2 at the bottom side 29, and there is a collector electrode 33 at the collector region 26. If the drift region 23 is n-doped, then the collector region 26 is p-doped, and vice versa. For example, for a maximum doping concentration of the collector region 26 the same may apply as for the at least one channel region 22. As an option, there can be a buffer region 28 of the first conductivity type between the collector region 26 and the drift region 23. Such a buffer has a higher maximum doping concentration than the drift region 23, for example.

Further, in Figure 14 it is illustrated that the trench 4 is of saw tooth like fashion, seen in top view. As in Figure 13, there is no straight line solely running within the trench 4 and connecting opposite ends of the trench 4 along the direction L.

According to Figure 14, seen in top view, the trench 4 has tips pointing away from a center axis of the trench 4 along the direction L. Other than shown, these tips may be rounded, or may be replaced by section running in parallel with the direction L. These modifications are analogously also possible in all other embodiments of the invention and in not claimed examples.

Like in the embodiments of the invention and in the examples not forming part of the invention, as respectively shown in Figure 6 to 13, in Figure 14 the optional plugs 25 may be distant from the trench 4, or may otherwise be in contact with the trench 4.

Otherwise, the same as to Figures 1 to 13 may also apply for Figure 14.

Figure 15 shows simulation data to prove the advantages of the proposed trench design, in top view of the top side 20 and, thus, in a xy plane. Only a slice of the basic unit has been simulated as depicted in Figure 15. Although simulations show different effects in current conduction at the corners of the trench due to thicker or thinner oxide in those locations, the output characteristics in Figure 15 indicates that the overall effect leads to a reduction of R_{ON}. In practice, the corners of the trench are usually rounded in order to minimize the crowding of electric field lines at the sharp points, and the side walls 44 may also have various angles, comapre, for example, Figure 8 to 12 and 14.

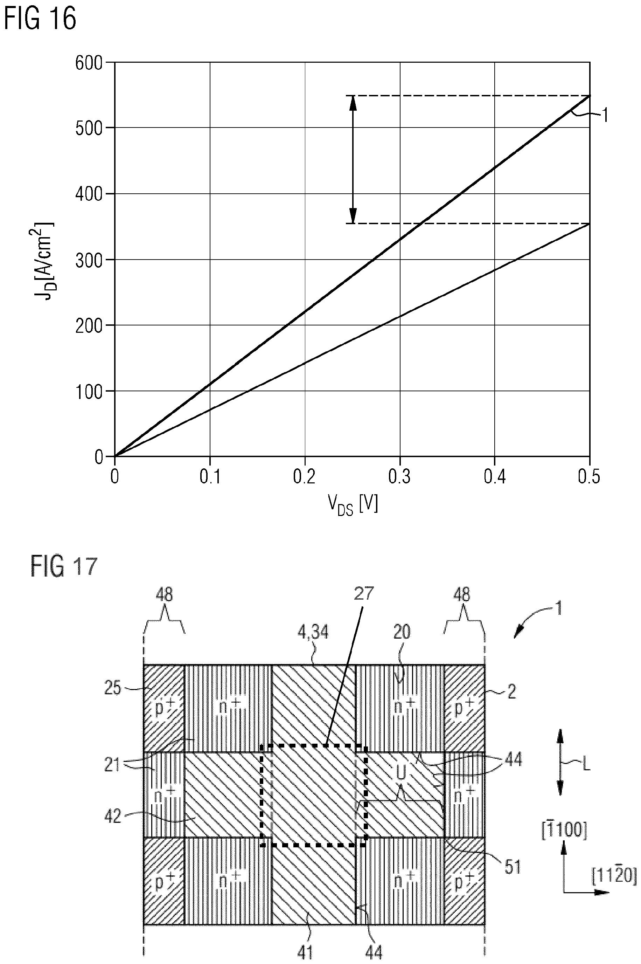

In Figure 16, a comparison of output I-V curves at a gate-source voltage of 15 V between the power semiconductor device 1 described herein and a device having only a stripe-like trench structure. The resulting drain current vs. source-drain voltage curves at the gate-source voltage of 15V allow to evaluate a reduction of approximately 36% in an on-resistance R_{ON} for the herein described step-like design as illustrated, for example, in Figure 6.

In the examples of Figures 17 to 19, there is the shield region 27 below part of the trench 4. In Figures 17 to 19, the branch-offs 42 are of rectangular shape, seen in top view, and are exactly opposite one another on pairs along the central pipe 41, but likewise the branch-offs 42 can be of trapezoidal shape as in Figures 8 to 10. Further, the source regions 21 and the plugs 25 can also be shaped like in Figures 7 or 9. Opposite ones of the branch-offs 42 can optionally be displaced along the central pipe 41 relative to one another, for example, for at most 20% or for at most 40% of an extent of the respective branch-offs 42 along the central pipe 41.

The function of the shield region 27 is to protect the bottom edges and corners of the trenches 4 from high electric field during blocking condition. When high voltage is applied between source and drain during blocking, a high value of the electric field tends to build up at the dielectric/semiconductor interface at the bottom of the trench 4, especially at the sharp corners and edges. The concentrated field at those points can lead to dielectric breakdown and device failure.

The layout that gives highest protection for the trench 4 would be having the shield region 27 covering the entire bottom of the central pipe 41 as well as of the branch-offs 42, not shown, but it has the disadvantage during conduction as it creates large depletion regions around the vertical channel, that is, along the trench wall 44, potentially causing high JFET effect and constraining the current flow, that is, increasing the total on-state resistance.

To minimize this effect, other layouts are possible where the area of the shield region 27 below the trench 4 is reduced. One possibility, according to an example not forming part of the present invention but useful for its understanding, is to limit the extension of the shield region 27 only to an intersection region between the central pipe 41 and the branch-offs 42, see Figure 17. In this case, the effects on the on-state resistance at the trench walls 44 are minimized, and the rest of the trenches 4 could still be protected, for example, if the parameters as doping, dimensions and os on are properly chosen by the effect of the depletion region generated by different adjacent shield regions 27 which are formed like separate islands.

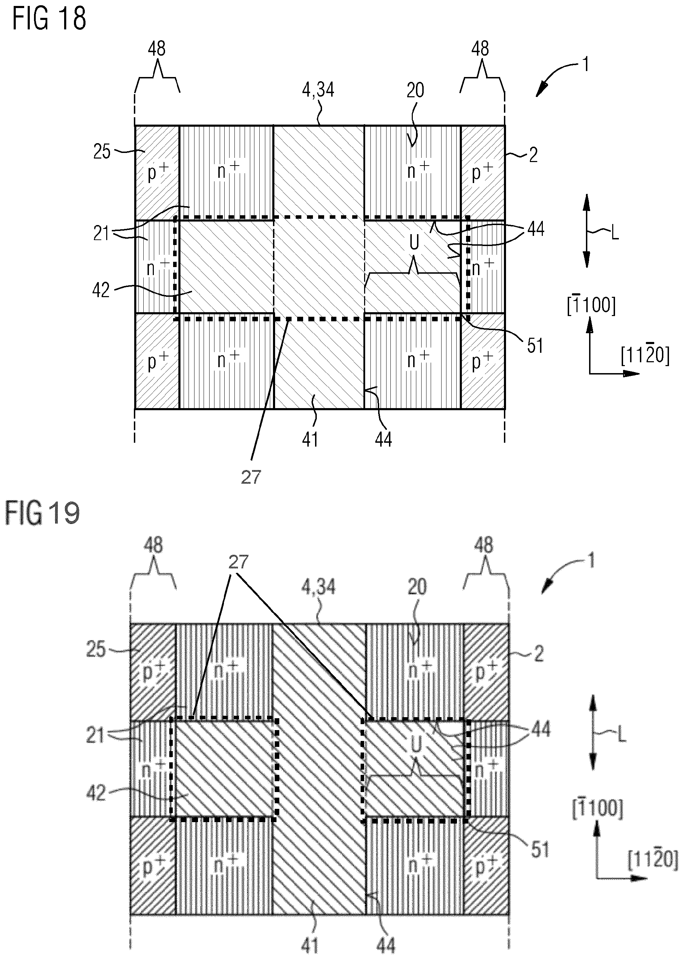

According to a further example not forming part of the present invention but useful for its understanding, according to Figure 18, the shield region 27 is formed as a bar below a pair of opposite branch-offs 42 and the part of the central pipe 41 between said branch-offs 42. That is, a pluraltiy of said bars can follow one another along the central pipe 41.

In Figure 19, the shield region 27 is also island-like, and according to the invention, the shield region 27 is limited to the branch-offs 42.

In other designs useful for understanding the invention, not shown, the trench 4 may entirely provided with the shield region 27, or the shield region 27 could be limited to the central pipe 41, seen in top view of the top side 20.

The shield region 27 can be realized by proper masking and implantation and/or by an epi - implantation - epi process.

### List of Reference Signs

- 1: power semiconductor device
- 2: semiconductor body
- 20: top side
- 21: source region
- 22: channel region
- 23: drift region
- 24: drain region
- 25: plug
- 26: collector region
- 27: shield region
- 28: buffer region
- 29: bottom side
- 31: source as well as channel region electrode
- 32: drain electrode
- 33: collector electrode
- 34: gate electrode
- 35: gate insulator
- 4: trench
- 41: central pipe
- 42: branch-off
- 44: side wall of the trench
- 46: trench bottom
- 48: strip
- 51: contact point
- 52: overlap region
- A: angle
- B: inner leg length
- G: growth direction
- L: direction of longest extent of the trench
- U: minimum size of a structural unit
- x,y: coordinate

## Claims

1. A power semiconductor device (1) comprising:
- a semiconductor body (2),
- source regions (21) of a first conductivity type in the semiconductor body (2) at a top side (20) thereof,
- at least one channel region (22) of a second conductivity type in the semiconductor body (2) below the source regions (21),
- a plurality of plugs (25) of the second conductivity type in the semiconductor body (2) at the top side (20) of the semiconductor body (20), said plugs providing electric contact paths from the top side (20) to the at least one channel region (22), It
- a drift region (23) of the first conductivity type in the semiconductor body (2) below the at least one channel region (22),
- at least one trench (4) running from the top side (20) through the source regions (21) and through the at least one channel region (22) and ending in the drift region (23), and
- a shield region (27) which is of the second conductivity type and which is located below at least a part of the bottom side (29) of the at least one trench (4),
wherein
- the at least one trench (4) accommodates a gate electrode (34) which is electrically separated from the semiconductor body by means of a gate insulator (35),
- seen in top view of the top side (20), the at least one trench (4) comprises non-linearly running side walls (44),
- seen in top view of the top side (20), the at least one trench (4) comprises a plurality of branch-offs (42) and comprises a central pipe (41) running straightly, each of the plurality of branch-offs (42) branches from the central pipe (41), the shield region (27) extends at least partially below at least one of the branch-offs (42),
- the shield region (27) is limited to the branch-offs (42) so that at least 90% of an area of the central pipe (41) is free of the shield region (27), seen in top view of the top side (20), and
- seen in top view of the top side (20), there are straight strips (48) next to the at least one trench (4), the at least one trench (4) is located between two adjacent straight strips (48), in the straight strips (48), portions of the at least one source region (21) and plugs (25) of the second conductivity type are arranged in an alternating manner,
- the plugs (25) and the at least one channel region (22) are connected,
- the source regions (21) are disposed at front ends of the branch-offs (42) so that at corners of the branch-offs (42) close to the strips (48), the plugs (25) touch the trench (4), or the source regions (21) between adjacent branch-offs (42) merge with the source regions (21) in the strips (48) so that one continuous source region (21) per side wall (44) is provided,
- areas between adjacent branch-offs (42) are composed of the source regions (21), and
- branch-offs are provided on both sides of central pipe, so that each side wall comprises a plurality of branch-offs.

2. The power semiconductor device (1) according to the preceding claim,
wherein at least some of the branch-offs (42) are of trapezoidal shape, seen in top view of the top side (20), wherein the branch-offs (42) of trapezoidal shape widen in a direction away from the central pipe (41), seen in top view of the top side (20).

3. The power semiconductor device (1) according to claim 1, wherein at least some of the branch-offs (42) are of trapezoidal shape, seen in top view of the top side (20), wherein the branch-offs (42) of trapezoidal shape narrow in a direction away from the central pipe (41), seen in top view of the top side (20).

4. The power semiconductor device (1) according to any one of the preceding claims,
wherein the semiconductor body (2) is of silicon carbide, SiC, and a direction (L) of main extent of the at least one trench (4) runs along a [1100]-direction of the SiC, and wherein each one of the side walls (44) comprises at least one portion next to the at least one source region (21) running transversely to the [1100]-direction of the SiC.

5. The power semiconductor device (1) according to any one of the preceding claims,
wherein, seen in top view of the top side (20), an overall length of each one of the side walls (44) exceeds a length of the at least one trench (4) by at least a factor of 1.2.

6. The power semiconductor device (1) according to any one of the preceding claims,
wherein, with a tolerance of at most 15°, the side walls (44) are oriented perpendicular to the top side (20) and a trench bottom (46) runs in parallel with the top side (20).

7. The power semiconductor device (1) according to claim 1,
wherein at least some of the branch-offs (42) are of trigonal shape or of square shape or of rectangular shape, seen in top view of the top side (20).

8. The power semiconductor device (1) according to any one of the preceding claims,
comprising a plurality of the trenches (4),
wherein, seen in top view of the top side (20), the trenches (4) and the associated source regions (21) are arranged in an alternating manner in a direction transverse to the trenches (4) .

9. The power semiconductor device (1) according to any one of the preceding claims,
wherein the power semiconductor device (1) is a field-effect transistor or an insulated gate bipolar transistor.

## Patentansprüche

1. Leistungshalbleiterbauelement (1), Folgendes umfassend:
- einen Halbleiterkörper (2),
- Source-Bereiche (21) eines ersten Leitfähigkeitstyps in dem Halbleiterkörper (2) an einer Oberseite (20) davon,
- mindestens einen Kanalbereich (22) eines zweiten Leitfähigkeitstyps in dem Halbleiterkörper (2) unter den Source-Bereichen (21),
- mehrere Pfropfen (25) des zweiten Leitfähigkeitstyps in dem Halbleiterkörper (2) an der Oberseite (20) des Halbleiterkörpers (20), wobei die Pfropfen elektrische Kontaktwege von der Oberseite (20) zu dem mindestens einen Kanalbereich (22) bereitstellen,
- einen Driftbereich (23) des ersten Leitfähigkeitstyps in dem Halbleiterkörper (2) unter dem mindestens einen Kanalbereich (22),
- mindestens einen Graben (4), der von der Oberseite (20) durch die Source-Bereiche (21) und durch den mindestens einen Kanalbereich (22) verläuft und in dem Driftbereich (23) endet, und
- einen Abschirmbereich (27), der vom zweiten Leitfähigkeitstyp ist und der unter mindestens einem Teil der Unterseite (29) des mindestens einen Grabens (4) lokalisiert ist,
wobei
- der mindestens eine Graben (4) eine Gate-Elektrode (34) beherbergt, die mittels eines Gate-Isolators (35) elektrisch von dem Halbleiterkörper getrennt ist,
- in Draufsicht auf die Oberseite (20) gesehen, der mindestens eine Graben (4) nicht linear verlaufende Seitenwände (44) umfasst,
- in Draufsicht auf die Oberseite (20) gesehen, der mindestens eine Graben (4) mehrere Abzweige (42) umfasst und eine Zentralleitung (41) umfasst, die gerade verläuft, wobei jeder der mehreren Abzweige (42) aus der Zentralleitung (41) abzweigt, wobei sich der Abschirmbereich (27) mindestens teilweise unter mindestens einem der Abzweige (42) erstreckt,
- der Abschirmbereich (27) auf die Abzweige (42) begrenzt ist, so dass mindestens 90 % einer Fläche der Zentralleitung (41) frei von dem Abschirmbereich (27) ist, gesehen in Draufsicht auf die Oberseite (20), und
- in Draufsicht auf die Oberseite (20) gesehen, es gerade Streifen (48) neben dem mindestens einen Graben (4) gibt, der mindestens eine Graben (4) zwischen zwei benachbarten geraden Streifen (48) lokalisiert ist, in den geraden Streifen (48) Abschnitte des mindestens einen Source-Bereichs (21) und Pfropfen (25) des zweiten Leitfähigkeitstyps in einer alternierenden Weise angeordnet sind,
- die Pfropfen (25) und der mindestens eine Kanalbereich (22) verbunden sind,
- die Source-Bereiche (21) an Vorderenden der Abzweige (42) angeordnet sind, so dass die Pfropfen (25) an Ecken der Abzweige (42) nahe den Streifen (48) den Graben (4) berühren, oder sich die Source-Bereiche (21) zwischen benachbarten Abzweigen (42) mit den Source-Bereichen (21) in den Streifen (48) vereinigen, so dass ein kontinuierlicher Source-Bereich (21) pro Seitenwand (44) bereitgestellt wird,
- Bereiche zwischen benachbarten Abzweigen (42) aus den Source-Bereichen (21) zusammengesetzt sind und
- Abzweige auf beiden Seiten der Zentralleitung bereitgestellt sind, so dass jede Seitenwand mehrere Abzweige umfasst.

2. Leistungshalbleiterbauelement (1) nach dem vorhergehenden Anspruch,
wobei mindestens einige der Abzweige (42) von trapezförmiger Gestalt sind, gesehen in Draufsicht auf die Oberseite (20), wobei sich die Abzweige (42) von trapezförmiger Gestalt in einer Richtung weg von der Zentralleitung (41) weiten, gesehen in Draufsicht auf die Oberseite (20).

3. Leistungshalbleiterbauelement (1) nach Anspruch 1,
wobei mindestens einige der Abzweige (42) von trapezförmiger Gestalt sind, gesehen in Draufsicht auf die Oberseite (20), wobei sich die Abzweige (42) von trapezförmiger Gestalt in einer Richtung weg von der Zentralleitung (41) verengen, gesehen in Draufsicht auf die Oberseite (20).

4. Leistungshalbleiterbauelement (1) nach einem der vorhergehenden Ansprüche,
wobei der Halbleiterkörper (2) aus Siliziumcarbid, SiC, ist und eine Richtung (L) der Hauptausdehnung des mindestens einen Grabens (4) entlang einer [1100]-Richtung des SiC verläuft und wobei jede der Seitenwände (44) mindestens einen Abschnitt neben dem mindestens einen Source-Bereich (21) umfasst, der quer zu der [1100]-Richtung des SiC verläuft.

5. Leistungshalbleiterbauelement (1) nach einem der vorhergehenden Ansprüche,
wobei, in Draufsicht auf die Oberseite (20) gesehen, eine Gesamtlänge jeder der Seitenwände (44) eine Länge des mindestens einen Grabens (4) um mindestens einen Faktor von 1,2 überschreitet.

6. Leistungshalbleiterbauelement (1) nach einem der vorhergehenden Ansprüche,
wobei, mit einer Toleranz von höchstens 15°, die Seitenwände (44) senkrecht zu der Oberseite (20) orientiert sind und ein Grabenboden (46) parallel zu der Oberseite (20) verläuft.

7. Leistungshalbleiterbauelement (1) nach Anspruch 1,
wobei mindestens einige der Abzweige (42) von trigonaler Gestalt oder von quadratischer Gestalt oder von rechteckiger Gestalt sind, gesehen in Draufsicht auf die Oberseite (20).

8. Leistungshalbleiterbauelement (1) nach einem der vorhergehenden Ansprüche,
mehrere der Gräben (4) umfassend,
wobei, in Draufsicht auf die Oberseite (20) gesehen, die Gräben (4) und die dazugehörigen Source-Bereiche (21) in einer alternierenden Weise in einer Querrichtung zu den Gräben (4) angeordnet sind.

9. Leistungshalbleiterbauelement (1) nach einem der vorhergehenden Ansprüche,
wobei das Leistungshalbleiterbauelement (1) ein Feldeffekttransistor oder ein isolierter Gate-Bipolartransistor ist.

## Revendications

1. Dispositif (1) à semi-conducteur de puissance comportant :
- un corps semi-conducteur (2),
- des régions (21) de source d'un premier type de conductivité dans le corps semi-conducteur (2) au niveau d'une face supérieure (20) de celui-ci,
- au moins une région (22) de canal d'un second type de conductivité dans le corps semi-conducteur (2) au-dessous des régions (21) de source,
- une pluralité de plots (25) du second type de conductivité dans le corps semi-conducteur (2) au niveau de la face supérieure (20) du corps semi-conducteur (20), lesdits plots constituant des chemins de contact électrique de la face supérieure (20) à la ou aux régions (22) de canal,
- une région (23) de dérive du premier type de conductivité dans le corps semi-conducteur (2) au-dessous de la ou des régions (22) de canal,
- au moins une tranchée (4) passant de la face supérieure (20) à travers les régions (21) de source et à travers la ou les régions (22) de canal et se terminant dans la région (23) de dérive, et
- une région (27) d'écran qui est du second type de conductivité et qui est située au-dessous d'au moins une partie de la face inférieure (29) de la ou des tranchées (4),
- la ou les tranchées (4) accueillant une électrode (34) de grille qui est électriquement séparée du corps semi-conducteur au moyen d'un isolant (35) de grille,
- dans une vue de dessus de la face supérieure (20), la ou les tranchées (4) comportant des parois latérales (44) qui s'étendent de façon non linéaire,
- dans une vue de dessus de la face supérieure (20), la ou les tranchées (4) comportant une pluralité de ramifications (42) et comportant un tube central (41) qui s'étend de façon rectiligne, chacune de la pluralité de ramifications (42) se ramifiant à partir du tube central (41), la région (27) d'écran s'étendant au moins partiellement au-dessous d'au moins une des ramifications (42),
- la région (27) d'écran étant limitée aux ramifications (42) de telle sorte qu'au moins 90% d'une aire du tube central (41) soit exempte de la région (27) d'écran, dans une vue de dessus de la face supérieure (20), et
- dans une vue de dessus de la face supérieure (20), des bandes rectilignes (48) se trouvant près de la ou des tranchées (4), la ou les tranchées (4) étant situées entre deux bandes rectilignes (48) adjacentes, dans les bandes rectilignes (48), des parties de la ou des régions (21) de source et des plots (25) du second type de conductivité étant agencés de manière alternée,
- les plots (25) et la ou les régions (22) de canal étant connectés,
- les régions (21) de source étant disposées à des extrémités avant des ramifications (42) de telle sorte qu'à des angles des ramifications (42) proches des bandes (48), les plots (25) touchent la tranchée (4), ou les régions (21) de source entre des ramifications (42) adjacentes fusionnant avec les régions (21) de source dans les bandes (48) de telle sorte qu'une région (21) de source continue par paroi latérale (44) soit réalisée,
- les zones entre des ramifications (42) adjacentes étant composées des régions (21) de source, et
- des ramifications étant placées des deux côtés de tube central, de telle sorte que chaque paroi latérale comporte une pluralité de ramifications.

2. Dispositif (1) à semi-conducteur de puissance selon la revendication précédente,
au moins certaines des ramifications (42) étant de forme trapézoïdale, dans une vue de dessus de la face supérieure (20), les ramifications (42) de forme trapézoïdale s'élargissant dans une direction s'éloignant du tube central (41), dans une vue de dessus de la face supérieure (20).

3. Dispositif (1) à semi-conducteur de puissance selon la revendication 1,
au moins certaines des ramifications (42) étant de forme trapézoïdale, dans une vue de dessus de la face supérieure (20), les ramifications (42) de forme trapézoïdale se rétrécissant dans une direction s'éloignant du tube central (41), dans une vue de dessus de la face supérieure (20).

4. Dispositif (1) à semi-conducteur de puissance selon l'une quelconque des revendications précédentes,
le corps semi-conducteur (2) étant en carbure de silicium, SiC, et une direction (L) d'étendue principale de la ou des tranchées (4) s'étendant suivant une direction [1100] du SiC, et chacune des parois latérales (44) comportant au moins une partie voisine de la ou des régions (21) de source s'étendant transversalement à la direction [1100] du SiC.

5. Dispositif (1) à semi-conducteur de puissance selon l'une quelconque des revendications précédentes,
dans une vue de dessus de la face supérieure (20), une longueur globale de chacune des parois latérales (44) dépassant une longueur de la ou des tranchées (4) d'au moins un facteur 1,2.

6. Dispositif (1) à semi-conducteur de puissance selon l'une quelconque des revendications précédentes,
avec une tolérance d'au plus 15°, les parois latérales (44) étant orientées perpendiculairement à la face supérieure (20) et un fond (46) de tranchée s'étendant parallèlement à la face supérieure (20).

7. Dispositif (1) à semi-conducteur de puissance selon la revendication 1,
au moins certaines des ramifications (42) étant de forme trigonale ou de forme carrée ou de forme rectangulaire, dans une vue de dessus de la face supérieure (20).

8. Dispositif (1) à semi-conducteur de puissance selon l'une quelconque des revendications précédentes,
comportant une pluralité des tranchées (4),
dans une vue de dessus de la face supérieure (20), les tranchées (4) et les régions (21) de source associées étant agencées de manière alternée dans une direction transverse aux tranchées (4).

9. Dispositif (1) à semi-conducteur de puissance selon l'une quelconque des revendications précédentes,
le dispositif (1) à semi-conducteur de puissance étant un transistor à effet de champ ou un transistor bipolaire à grille isolée.
